# EUROPEAN PATENT APPLICATION

(11) **EP 4 766 048 A1**
(43) Date of publication of application: **24.06.2026**
(21) Application number: 24307176.8
(22) Date of filing: 18.12.2024
(51) Int. Cl.: H05K 7/20

(54) **SYSTEM AND METHOD FOR BALANCING POWER AND WATER CONSUMPTION OF DATACENTER EVAPORATIVE COOLING**

(71) Applicant: OVH, 59100 Roubaix (FR)
(72) Inventor: CHEHADE, Ali, 59283 Moncheaux (FR); HNAYNO, Mohamad, 59110 La Madeleine (FR); BAUCHART, Grégory Francis Louis, 59150 Wattrelos (FR)
(74) Representative: BCF Global

(57) **Abstract**

A datacenter dry cooling arrangement and method for cooling a heat-generating source containing a heat exchanger panel with an evaporative cooling pad. The arrangement and method incorporates temperature-, humidity-, and water flow-related data detected by respective sensors and a controller (500) configured with executable instructions to process the received data to generate operational parameters, determine whether a thermal load, input temperatures and outside ambient temperatures comply with specified operational thresholds and operatively adjust the cooling water flow rate applied to the evaporative cooling pad to optimal levels in view of prevailing ambient weather conditions.

## Description

### FIELD

The present technology generally relates to the field of datacenter cooling measures and, in particular, to an evaporative cooling arrangement for a dry cooling system.

### BACKGROUND

Datacenters are located all over the world and operate to support the data processing needs of consumers. As such, datacenters are designed to house and maintain a vast number of heat-generating electronic processing equipment, which includes providing cooling measures to ensure proper operations and mitigate any overheating issues.

Such cooling measures include datacenters that employ dry coolers and/or heat exchanger systems with fan assemblies that generate forced air to expel heat from circulating water in thermal contact with the heat-generating equipment. For example, a dry cooler/heat exchanger system may be configured to cool the heat from water circulated through water blocks thermally-coupled to the heat-generating electronic components, in which the heated water is exposed to the forced airflow provide by the fan assemblies to expel the heat therefrom into the ambient environment.

Additional cooling measures include evaporating cooling techniques that incorporate evaporative cooling pads within heat exchanger systems, such that cooling water is directly applied to the evaporative cooling pads, via measured dripping, spraying, streaming means, to precool ambient air flowing through the heat exchanger system.

However, as noted above, datacenters are geographically located all over the world and are, therefore, subject to prevailing climates/weather conditions which affect the cooling measures employed to ensure satisfactory data processing service. For example, given the weather conditions and available resources, a datacenter in Dubai, UAE will require different cooling measures employing a different set of power consumption and water usage levels than a datacenter located in Halifax, CA.

Therefore, although conventional cooling measures do provide certain benefits, there continues to remain an interest in improving datacenter power consumption and water usage levels for all climates and weather conditions.

It will be appreciated that the subject matter discussed in the background section is not be assumed or considered to be prior art merely as a result of its mention in the background section. Similarly, any problems or issues mentioned in the background section or associated with the subject matter of the background section should not be assumed to have been previously recognized in the prior art. The subject matter in the background section merely highlights certain shortcomings observed by the developers.

### SUMMARY

Embodiments of the present technology have been developed based on the shortcomings associated with the conventional dry cooling techniques and implementations. As such, the present technology is directed to achieving an optimal balance between power consumption levels and water usage levels of datacenter dry cooling arrangements.

In one embodiment of the present technology, there is provided a datacenter dry cooling method for cooling a heat-generating electronic processing source, the datacenter associated with a dry cooler unit that incorporates an air-to-water heat exchanger panel, an evaporative cooling pad, an evaporating cooling water distribution arrangement for applying cooling water to the evaporative cooling pad, and a controller. The method including receiving, by the controller (500), temperature-, humidity-, and water flow-related data detected by respective sensors; processing the received data to generate operational parameters that include a thermal load Q value based, in part, on an inlet cooling water temperature Tᵢ value and an outlet cooling water temperature Tₒ value, a theoretical ambient cooling pad temperature T_{amb-cp-theo} value based, in part, on an outside ambient temperature T_{amb} value and an inlet relative humidity RHᵢ value, a cooling water target flow rate W_{f-targ} based, in part, on the cooling water flow rate W_{f} applied to the cooling pad, a cooling pad low-level temperature T_{amb-cp-low} value that ranges between an upper temperature limit T_{amb-cp-low-up} value and a lower temperature limit T_{amb-cp-low-down} value, and a maximum cooling water consumption level W_{cp-max} value and a minimum cooling water consumption level W_{cp-min} value that are based, in part, on a theoretical cooling water consumption level W_{cp-theo}.

The method further includes determining a first condition comprising whether thermal load Q value is ≤ Z kW and Tᵢ is > C °C or whether the Q value is > Z kW and Tᵢ is > D °C, wherein in response to determining that the first condition is satisfied, determining a second condition comprising whether the outside ambient temperature T_{amb} value is ≥ B °C, and determining a third condition comprising whether the theoretical ambient temperature after the evaporative cooling pad T_{amb-cp-theo} value is ≤ A °C; wherein in response to determining that the second and third conditions are satisfied, an inlet cooling water temperature target T_{in-targ} value is set to A °C.

In a related aspect, the method further includes setting the target cooling water flow rate W_{f-targ} to the maximum cooling water consumption level W_{cp-max}, determining a fourth condition comprising whether the outside relative humidity RH_{amb} value is > 95% and the theoretical ambient temperature T_{amb-cp-theo} value ≤ A °C, wherein in response to determining that the fourth condition is satisfied, T_{mid-targ} is set to equal A°C, determining a fifth condition comprising whether the outside relative humidity RH_{amb} value is > 95% and the theoretical ambient temperature T_{amb-cp-theo} value is > A °C, wherein in response to determining that the fifth condition is satisfied, T_{mid-targ} is set to equal T_{amb-cp-theo}. And, in response to determining that either the fourth or fifth conditions is satisfied, determining a sixth condition comprising whether the cooling pad low-level temperature T_{amb-cp-low} value is ≤ the upper temperature limit T_{amb-cp-low-up} value and determining a seventh condition comprising whether the cooling pad low-level temperature T_{amb-cp-low} value is < the lower temperature limit T_{amb-cp-low-down} value, wherein, in response to determining that the sixth and seventh conditions are satisfied, setting the the target cooling water flow rate W_{f-targ} to the minimum cooling water consumption level W_{cp-min}.

In another related aspect, the method further includes receiving, by the controller, a cooling pad water saturation level sensor disposed at different heights of the cooling pad to determine cooling pad water absorption levels at different cooling pad heights. The cooling pad water saturation level sensor comprises a cannula configured with an exposed opening to extract water samples and coupled to a capacitive, conductivity, or optical sensor, a resistive probe configured to measure the resistance values indicative of saturation levels, a high definition (HD) camera configured to observe the color of the cooling pad or flickering due to reflections caused by progressing water saturation levels, or a comprises a thermal camera configured to detect temperatures by capturing different levels of infrared light indicative of warm and cool areas of the cooling pad.

In another embodiment of the present technology, there is provided a datacenter dry cooling arrangement for cooling a heat-generating electronic processing source, the datacenter associated with a dry cooler unit that incorporates an air-to-water heat exchanger panel, an evaporative cooling pad, an evaporating cooling water distribution arrangement for applying cooling water to the evaporative cooling pad, and a controller. The controller communicatively-coupled to temperature-, humidity-, and water flow-related data detected by respective sensors; processing the received data to generate operational parameters that include a thermal load Q value based, in part, on an inlet cooling water temperature Tᵢ value and an outlet cooling water temperature Tₒ value, a theoretical ambient cooling pad temperature T_{amb-cp-theo} value based, in part, on an outside ambient temperature T_{amb} value and an inlet relative humidity RHᵢ value, a cooling water target flow rate W_{f-targ} based, in part, on the cooling water flow rate W_{f} applied to the cooling pad, a cooling pad low-level temperature T_{amb-cp-low} value that ranges between an upper temperature limit T_{amb-cp-low-up} value and a lower temperature limit T_{amb-cp-low-down} value, and a maximum cooling water consumption level W_{cp-max} value and a minimum cooling water consumption level W_{cp-min} value that are based, in part, on a theoretical cooling water consumption level W_{cp-theo}.

The controller of the datacenter dry cooling arrangement further configured to operatively execute the processing steps of the datacenter dry cooling method noted above.

Within the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

Additionally, within the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

Relatedly, within the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but may not, necessarily include all of them.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1A illustrates a conceptual representation of a datacenter dry cooler unit, in accordance with the nonlimiting embodiments of the present technology;
FIG. 1B illustrates a high-level functional block general overview diagram of a datacenter dry cooling arrangement, in accordance with the nonlimiting embodiments of the present technology;
FIG. 2A illustrates a datacenter evaporative cooling water distribution arrangement, in accordance with the nonlimiting embodiments of the present technology;
FIGs. 2B, 2C, 2D, 2E illustrate different implementations of an evaporative cooling pad saturation level sensor, in accordance with the nonlimiting embodiments of the present technology;
FIG. 3 illustrates a functional flow diagram depicting processing steps of a main evaporative cooling control process, in accordance with non-limiting embodiments of the present technology;
FIG. 4A illustrates a functional flow diagram depicting processing steps of a cooling pad saturation process, in accordance with the non-limiting embodiments of the present technology;
FIG. 4B illustrates a functional flow diagram depicting processing steps of a humidification status process, in accordance with the non-limiting embodiments of the present technology;
FIG. 4C illustrates a functional flow diagram depicting processing steps of a drying process, in accordance with the non-limiting embodiments of the present technology; and
FIG. 5 illustrates a functional block diagram of monitoring controller configured to execute the various operations performed by the processing steps depicted by FIGs. 3-4C, in accordance with non-limiting embodiments of the present technology.
It should be appreciated that, unless otherwise explicitly specified herein, the features depicted by the figures are not drawn to scale and, for purposes of understanding and/or clarity, the figures may omit or exaggerate certain features.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the figures including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some embodiments of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

With this said, the present technology is directed to achieving an optimal balance between fan power consumption levels and water usage levels of datacenter dry cooling arrangements in view of ambient weather conditions.

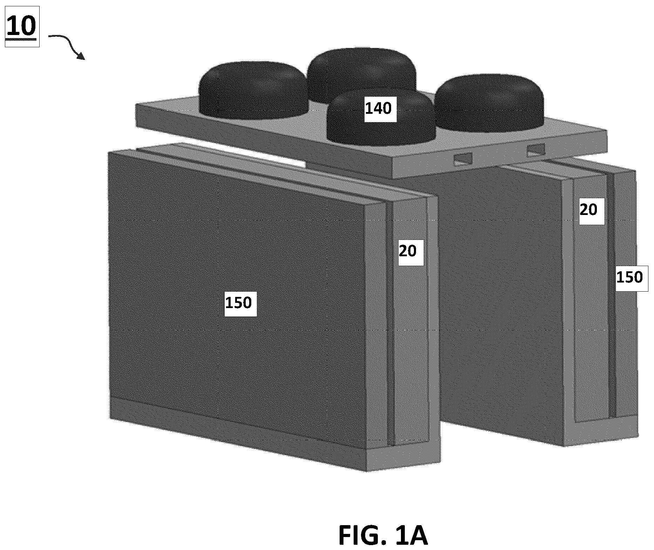

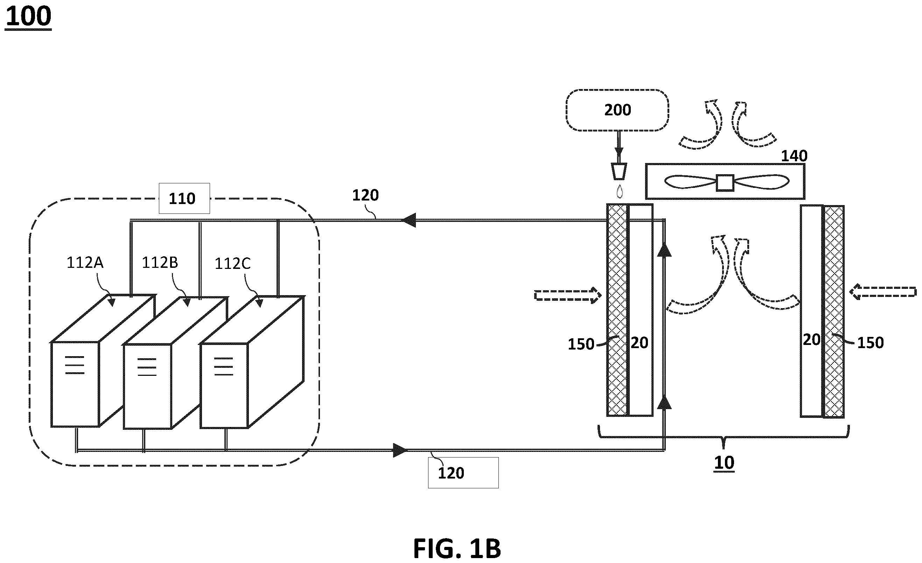

Accordingly, FIG. 1A illustrates a conceptual representation of a dry cooler unit **10** and FIG. 1B illustrates a high-level functional block general overview diagram of a dry cooling arrangement **100,** in accordance with the nonlimiting embodiments of the present technology. The dry cooler unit **10** may be located on any suitable support surface, such as, for example, the roof of a datacenter building or stable surface in close proximity to the datacenter. As shown, dry cooler unit **10** generally comprises the basic following components: at least one heat exchanger panel **20,** at least one fan assembly **140,** and at least one evaporative cooling pad **150.**

The heat exchanger panel **20** operates to expel heated thermal energy of a cooling water, flowing through and warmed by rack-mounted heat-generating electronic processing assemblies, into the ambient environment. That is, the heat exchanger panel **20** is configured as a liquid-to-air heat exchanger, having an air inlet side (*not shown*) for receiving ambient air flow and an air outlet side (*not shown*) for expelling heated air. The heat exchanger panel **20** also incorporates cooling coils (*not shown*), in which warmed cooling water circulates therethrough via a cooling water closed loop **120.**

As indicated in FIG. 1B, the cooling water closed loop **120** conveys the cooling water to processing servers **112A-C** (collectively referred to as "heat source **110"**) that house the rack-mounted heat-generating electronic processing assemblies (*not shown*). The cooling water is supplied to water cooling blocks (*not shown*) in direct thermal contact to the heat-generating electronic processing components for cooling purposes. The cooling water absorbs the generated heat and the warmed cooling water is circulated, via the cooling water closed loop **120** back to the dry cooler unit **10** for extracting and dissipating the thermal energy therein and recooling the cooling water.

The fan assembly **140** is disposed on an upper surface of the dry cooler unit **10** and is configured to forcibly cause ambient air flow throughout the dry cooler **10.** The fan assembly **140** comprises a plurality of fans located at an upper end of the dry cooler unit **10.** The fan assembly **140** includes respective motors (*not shown*) that drive each of the fans to rotate and forcibly pull ambient air from a lateral side of the dry cooler **10** towards an interior space of the dry cooler unit **10.** Depending on the amount of thermal energy needed to be dissipated for recooling the water, the energy consumption of the fan assembly **140** can be substantial.

The heat exchanger panel **20** (along with respective cooling coils) is exposed to the forcibly pulled-in ambient air produced by the fan assembly **140.** In turn, the thermal energy manifested by the warmed first cooling water circulating through the cooling coils is transferred, via the outlet side, and expelled vertically upwards from the dry cooler unit **10** into the ambient environment. As will be described in greater detail below, the quantity of electrical power used by the fans to forcibly pull adequate air levels is a factor to be considered in assessing consumption levels.

The evaporative cooling pad **150** is positioned to directly abut an outer lateral surface of the heat exchanger panel **20.** The evaporative cooling pad **150** is configured to absorb a cooling water applied thereto while enabling air flow to pass through the pad surface. The evaporative cooling pad **150** comprises an air inlet surface (*not shown*) for receiving the air flow and an air outlet surface (*not shown*) for expelling the forced air flow. The evaporative cooling pad **150** may be made of plastic material, cellulose, glass fibers, *etc.* to absorb the applied cooling water.

The evaporative cooling pad **150** operates to receive cooling water from an evaporative cooling water distribution arrangement **200.** The evaporative cooling arrangement **200** is configured to apply a specifically-controlled measured amount of evaporative cooling water, based on certain detected operational factors, to wet the evaporative cooling pad **150** for optimal cooling performance while virtually eliminating any water leakages. As will be described in greater detail below, the quantity of water used to adequately wet the evaporative cooling pad **150** is another factor to be considered in assessing consumption levels.

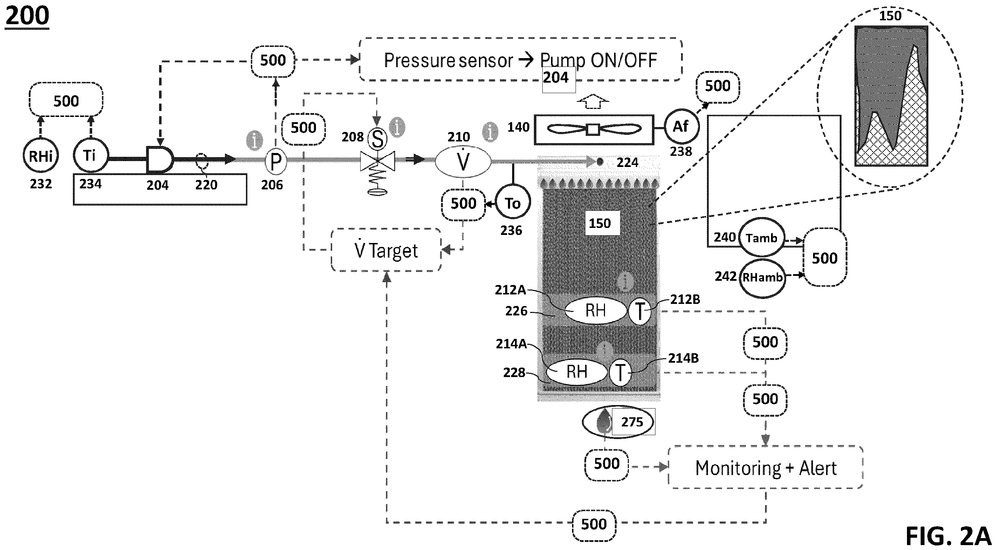

FIG. 2A illustrates an evaporative cooling water distribution arrangement **200,** in accordance with the nonlimiting embodiments of the present technology. The evaporative cooling water is forwarded throughout the system by a pump unit **204** that is configured to forcibly urge the flow of the evaporative cooling water throughout the distribution conduit **220** for conveyance to fluidly-coupled components and sensors. It will be appreciated that the evaporative cooling water may comprise deionized water, osmosed water, or any other type of treated/processed water that is free from minerals or contaminants. Moreover, as described in detail below, the sensors and components are communicatively-coupled to a monitoring controller **500** configured to receive and process measurement data from the sensors to control operations of the fluidly-coupled components.

As such, on an inlet side of the distribution conduit **220** the inlet evaporative cooling water temperature, the ambient relative humidity, and the pressure level of the evaporative cooling water flow pressure are respectively detected by sensors Tᵢ **234,** RHᵢ **232,** pressure sensor **206.**

The distribution conduit **220** conveys the evaporative cooling water to a "smart" volume flow control valve **208.** The smart flow control valve **208** comprises a solenoid-controlled valve, such as an automatic balancing pressure control valve (ABQM). The output flow rate W_{f} of the evaporative cooling water from the smart flow control valve **208** is detected by flow rate sensor **210.**

The evaporative cooling water is further conveyed to a water distribution unit **224** configured to apply the cooling water to the evaporative cooling pad **150,** in which the outlet temperature of the cooling water is detected by Tₒ sensor **236.** The water distribution unit **224** may comprise a nozzle or a series of nozzles, a fluid discharge manifold, a sprayer, or any structure that uniformly dispenses the cooling water across the width dimension of an upper surface of the cooling pad **150.**

As shown, the cooling pad **150** is associated with humidity sensors **212A, 214A** and/or temperature sensors **212B, 214B** on the air outlet surface for detecting the ambient relative humidity and temperature levels along the evaporative cooling pad. The air inlet and outlet surfaces of the evaporative cooling pad **150** may implement a first (mid-level) monitoring band **226** across the width dimension of the evaporative cooling pad **150** that includes a humidity sensor **212A** to detect the ambient cooling pad relative humidity RH_{amb-cp-mid} and a temperature sensor **212B** to detect the ambient cooling pad temperature T_{amb-cp-mid} along the first band **226.**

The evaporative cooling pad **150** may further implement and a second (low-level) monitoring band **228** across the width dimension of the evaporative cooling pad **150** that is positioned lower than the first band **226** at the outlet surface of the evaporative cooling pad **150.** By way of dimensional reference, the first monitoring band **226** is disposed below a halfway point of the evaporative cooling pad **150** vertical dimension and the second monitoring band **228** is disposed below the first monitoring band **226.** The second (low-level) monitoring band **228** includes a humidity sensor **214A** to detect the ambient cooling pad relative humidity RH_{amb-cp-low} and a temperature sensor **212B** to detect the ambient cooling pad temperature T_{amb-cp-low} along the second band **228.**

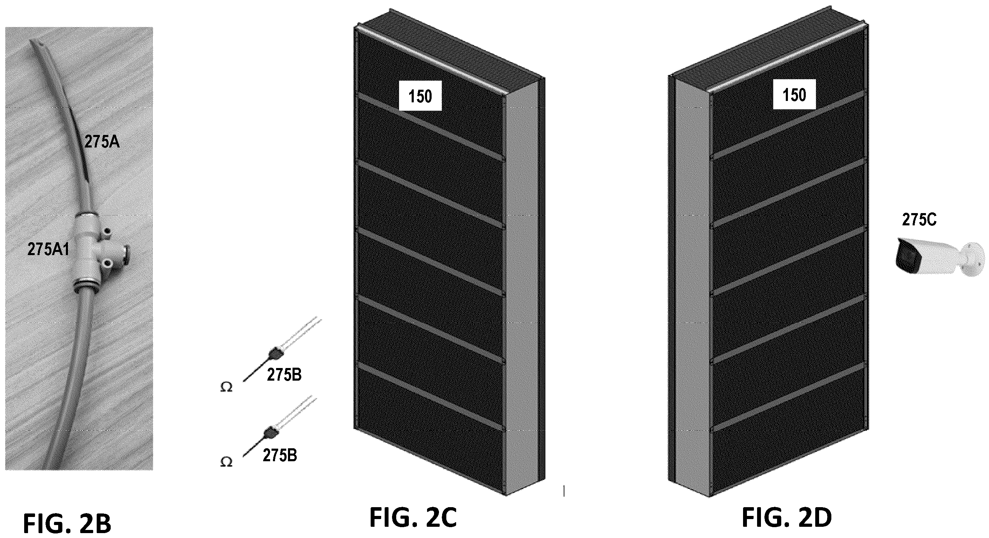

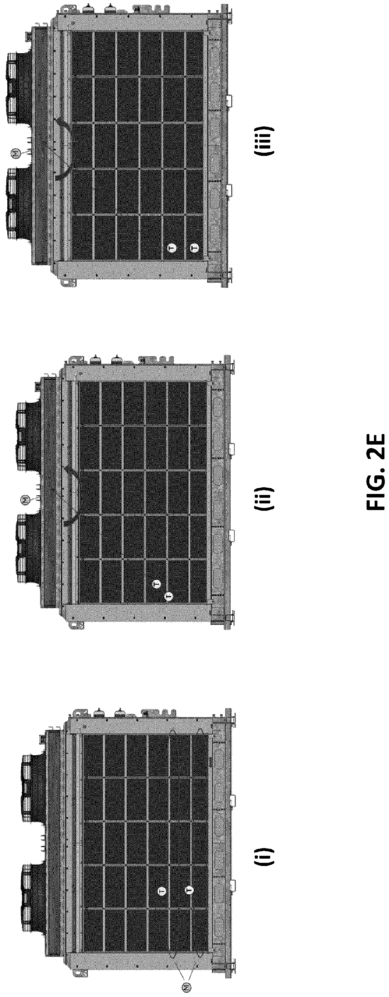

The relative positioning of the first (mid-level) and second (low-level) monitoring bands **226, 228** is based on the developer's observation that, while the evaporating cooling water is applied uniformly, the actual absorption of the cooling water is nonuniform throughout the evaporative cooling pad **150.** That is, as conceptually represented in the circular insert of FIG. 2, because of the material composition of the evaporative cooling pad **150,** the absorption level of the cooling water along the pad is very irregular, as it varies along different areas of the evaporative cooling pad **150.**

Turning back to FIG. 2A, the airflow rate of fan assembly **140,** which is indicative of fan rotational speed and fan energy consumption, is detected by A_{f} sensor **238.** Moreover, the outside ambient air temperature T_{amb} and relative humidity RH_{amb} are respectively detected by sensors **240, 242.**

Additionally, evaporative cooling water distribution arrangement **200,** further comprises a saturation level sensor **275** that is configured to detect cooling water saturation levels provided by evaporative cooling water distribution arrangement **200** at different heights of the cooling pad **150.** In certain implementations, as depicted by FIG. 2B in accordance with the nonlimiting embodiments of the present technology, saturation level sensor **275** comprises a cannula **275A** having a lengthwise sliced opening with T-coupler **275A1.** The T-coupler **275A1** includes a mounted capacitive, conductivity, or optical sensor (*not shown*). The cannula **275A** is positioned at different heights of cooling pad **150** and extracts small amounts cooling water samples for measurement levels and then reintroduces the water samples back to the cooling pad **150.** The measured cooling water levels are then reported to the monitoring controller **500.**

In an alternative implementation, as depicted by FIG. 2C in accordance with the nonlimiting embodiments of the present technology, saturation level sensor **275** comprises a plurality of resistivity probes **275B** positioned at different heights of cooling pad **150.** The resistivity probes **275B** are configured to measure the resistance levels at each of the heights, which are indicative of saturation levels. The measured resistance levels are then reported to the monitoring controller **500.**

In another alternative implementation, as depicted by FIG. 2D in accordance with the nonlimiting embodiments of the present technology, saturation level sensor **275** comprises the saturation level sensor **275** comprises a high definition (HD) camera **275C.** The HD camera **275C** is configured to observe the color of the cooling pad **150** which manifests a lighter color when dry and becomes a darker color when wet. The HD camera **275C** captures the color of the different regions of the entire cooling pad **150.** In addition to color changes, the HD camera **275C** may also be configured to capture flickering due to reflections caused by progressing water saturation. During evenings or periods of darkness, the HD camera **275C** imaging may be assisted by a spot light directed towards the cooling pad **150.** The imaging captured by the HD camera **275C** is then forwarded to the monitoring controller **500** for real-time evaluation, such as, for example, Al-based analyses.

In a related aspect, the HD camera **275C** may comprise a thermal camera configured to detect temperatures by capturing different levels of infrared light that are displayed in different color gradients that identify warm and cool areas of the cooling pad. As such, when the cooling pad **150** is saturated with air passing therethrough, the thermal camera registers cool temperatures indicating efficient evaporative cooling operations and when the cooling pad **150** is dry, the thermal camera registers warm temperatures indicating inefficiencies of the evaporative cooling operations.

In another related aspect, as depicted by FIG. 2E, the thermal camera may be configured to scan across multiple cooling pads 150 in: (i) a lateral motion; (ii) in a radial sweeping motion; or (iii) a combination of the two.

As noted above, the sensors, namely, inlet evaporative cooling water temperature Tᵢ sensor **234,** ambient inlet relative humidity RHᵢ sensor **232,** outlet cooling water temperature Tₒ sensor **236,** pump pressure level sensor **206,** cooling water flow rate W_{f} sensor **210,** ambient mid-level cooling pad relative humidity RH_{amb-cp-mid} sensor **212A** and temperature T_{amb-cp-mid} sensors **212B,** ambient low-level cooling pad relative humidity RH_{amb-cp-low} sensor **214A** and temperature T_{amb-cp-low} sensor **214B,** fan airflow rate A_{f} sensor **238,** outside ambient air temperature T_{amb} sensor **240,** outside relative humidity RH_{amb} sensor **242,** and cooling pad saturation level sensor **275** are communicatively-coupled to monitoring controller **500.** The monitoring controller **500** is configured to receive and process the detected sensor data to determine various functional parameters and metrics for controlling operations of the evaporative cooling water distribution arrangement **200.**

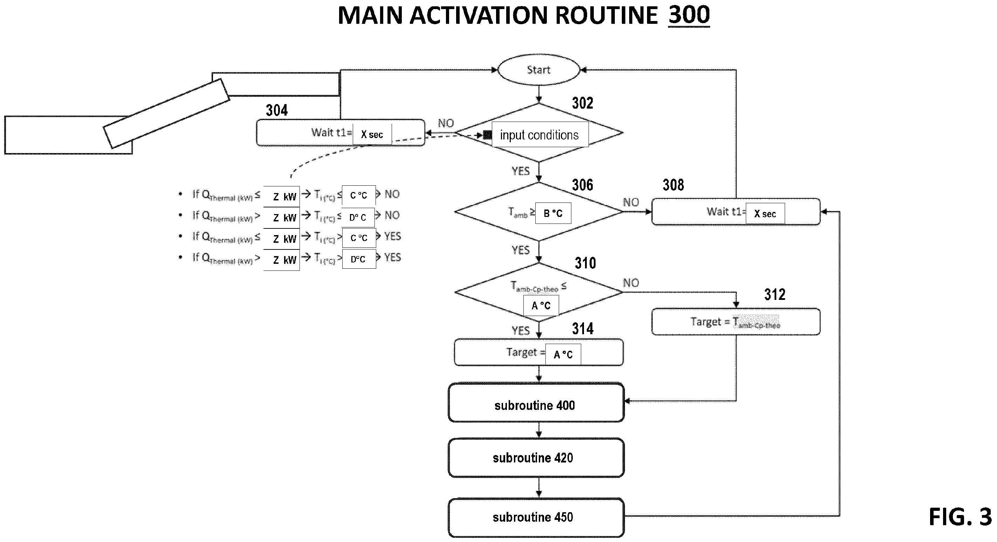

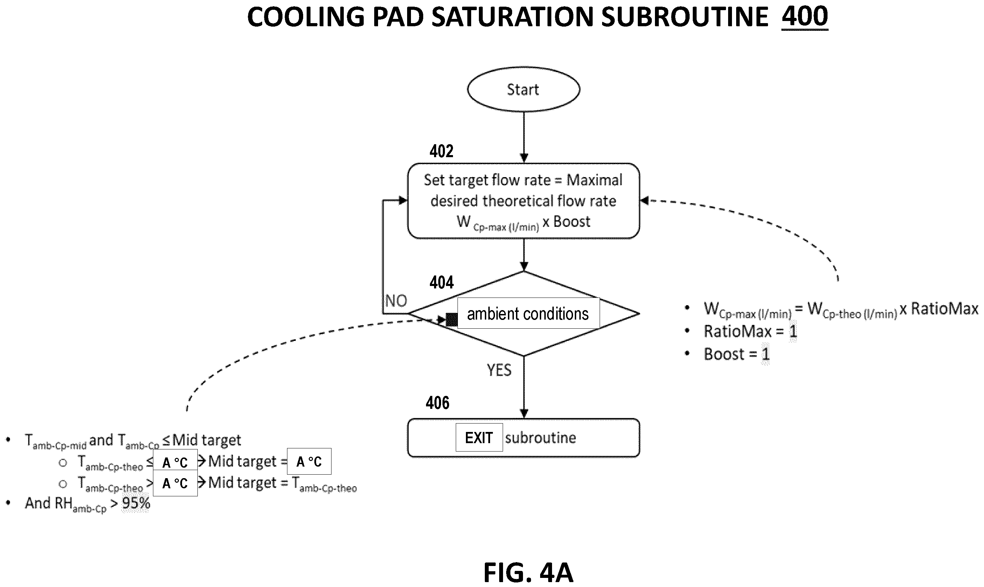

Consequently, armed with the noted parameters and metrics, monitoring controller **500** executes the various processes of evaporative cooling water distribution arrangement **200,** as described in detail by main process **300** and incorporated subprocesses **400, 420, 450** respectively depicted by FIGs. 3, 4A-4C, in accordance with non-limiting embodiments of the present technology. In tandem, processes **300, 400, 420, 450** operate to balance power consumption and water usage levels of the evaporative cooling water distribution arrangement **200** in view of ambient conditions.

FIG. 3 illustrates a functional flow diagram depicting the processing steps of main process **300,** in accordance with non-limiting embodiments of the present technology. Main process **300** is directed to determining whether processing operations are to be activated or continued in order to balance power consumption and water usage levels of the evaporative cooling water distribution arrangement **200** discussed above, given detected ambient conditions.

Process **300** starts at decision step **302** to determine whether the inlet water temperature Tᵢ detected by sensor **234** warrant triggering the activation of the remaining steps and processes in view of a thermal load Q. The thermal load Q value is determined as a function of the difference between the detected inlet cooling water Tᵢ and outlet cooling water Tₒ temperatures as well as airflow rate A_{f}. As such, if thermal load Q is ≤ Z kW and Tᵢ is > C °C or Q is > Z kW and Tᵢ is > D °C, then process **300** is activated to continue processing. If the Tᵢ and Q conditions are not met, then process **300** moves to step **304** and waits X sec. before restarting the initial determination step. If the Tᵢ and Q conditions are met, then process **300** moves to decision step **306** to determine whether the outside ambient temperature T_{amb} detected by sensor **240** is ≥ B °C. If not, the outside T_{amb} temperature is not sufficiently warm to require cooling and process **300** moves to step **308** and waits X sec. before restarting the initial determination step.

If the outside T_{amb} temperature is ≥ B °C, the process **300** progresses to decision step **310** to determine whether a theoretical ambient temperature after the evaporative cooling pad **150** T_{amb-cp-theo} is ≤ A °C. The theoretical ambient temperature T_{amb-cp-theo} is determined as a function of the T_{amb} temperature, air wet and dry temperatures before the cooling pad, and inlet relative humidity RHᵢ. As such, if T_{amb-cp-theo} is ≤ A °C, the target temperature T_{in-targ} for the inlet cooling water is set to A °C at step **314.** If not, process **300** moves to step **312** which sets T_{targ} to the theoretical ambient temperature T_{amb-cp-theo}. After steps **312** and/or **314,** process **300** progresses to subprocess **400** to continue operations directed to balancing power consumption and water usage levels.

FIG. 4A illustrates a functional flow diagram depicting the processing steps of subprocess **400,** in accordance with non-limiting embodiments of the present technology. Subprocess **400** is directed to ensuring that the evaporative cooling pads **150** are completely saturated with the cooling water as quickly as possible.

Accordingly, subprocess **400** commences at step **402** which sets a target cooling water flow rate W_{f-targ} to cooling pad **150** to the maximum cooling water consumption level W_{cp-max}. The maximum cooling water consumption level W_{cp-max} is based on a theoretical cooling water consumption level W_{cp-theo} multiplied by a maximizing factor *Rₘₐₓ.* The theoretical cooling water consumption level W_{cp-theo} is determined as a function of the airflow rate A_{f}, difference between the inlet relative humidity RHᵢ and outside relative humidity RH_{amb}, and air density. Moreover, if necessary to ensure complete cooling pad saturation in minimal time, W_{cp-max} may be multiplied by a boost factor *F_{boost}* to increase the maximum cooling water consumption rate W_{cp-max}.

Subprocess **400** advances to decision step **404** to determine whether certain ambient temperature conditions are satisfied after the maximum consumption rate W_{cp-max} is applied to the cooling pad. The ambient conditions relate to whether the outside relative humidity RH_{amb} is > 95% and the ambient mid-level cooling pad temperature T_{amb-cp-mid} as well as the ambient temperature after the cooling pads T_{amb} are less than or equal to a target mid-level temperature T_{mid-targ}. Specifically, decision step **404** determines that if RH_{amb} > 95% and T_{amb-cp-theo} < A °C, then T_{mid-targ} is set to equal A °C; or if RH_{amb} > 95% and T_{amb-cp-theo} > A °C, then T_{mid-targ} is set to equal T_{amb-cp-theo}. If none of these conditions are satisfied, subprocess **400** returns back to decision step **402** to reset the target flow rate. If either of these conditions are satisfied, subprocess **400** to progresses to step **406** to exit in preparation for the subsequent subprocess **420.**

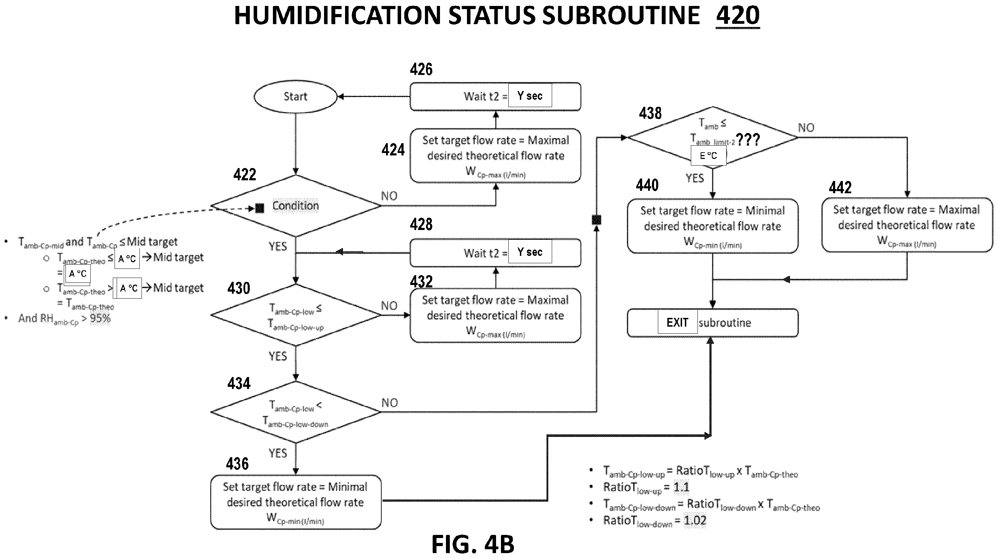

FIG. 4B illustrates a functional flow diagram depicting the processing steps of subprocess **420,** in accordance with non-limiting embodiments of the present technology. Subprocess **420** is directed to adjusting the humidification of the evaporative cooling pads **150** to suitable levels.

Subprocess **420** commences at decision step **422** where, like decision step **404** of process **400,** step **422** that if RH_{amb} > 95% and T_{amb-cp-theo} ≤ A °C, then T_{mid-targ} is set to equal A °C; or if RH_{amb} > 95% and T_{amb-cp-theo} > A °C, then T_{mid-targ} is set to equal T_{amb-cp-theo}. If not, subprocess moves to step **424** where the cooling water flow rate to cooling pad **150** is set to the maximum cooling water consumption level W_{cp-max} and then moves to step **426** to wait Y sec before restarting the subprocess.

If either of the conditions are satisfied, subprocess **420** to progresses to decision step **430** that ascertains the status of the ambient low-level cooling pad temperature T_{amb-cp-low}. That is, T_{amb-cp-low} may range between an upper temperature limit T_{amb-cp-low-up} and a lower temperature limit T_{amb-cp-low-down}. As such, decision step **430** determines whether the ambient low-level cooling pad temperature T_{amb-cp-low} is ≤ T_{amb-cp-low-up}. If not, subprocess **420** moves to step **432** to again reset the cooling water flow rate to cooling pad **150** to the maximum cooling water consumption level W_{cp-max} and then moves to step **428** to wait Y sec before being again subjected to decision step **430.**

If the ambient low-level cooling pad temperature T_{amb-cp-low} is ≤ T_{amb-cp-low-up}, subprocess **420** progresses to decision step **434** to determine whether T_{amb-cp-low} is < T_{amb-cp-low-down}. If so, at step **436,** the cooling water flow rate for cooling pad **150** is set to the minimum cooling water consumption level W_{cp-min} and proceeds to exit the subroutine.

However, if T_{amb-cp-low} is not < T_{amb-cp-low-down}, subprocess **420** progresses to decision step **438** to determine whether the outside ambient air temperature T_{amb} is ≤ T_{amb-limit2}. The T_{amb-limit2} is the temperature threshold that determines whether the evaporative cooling system operates at maximum or minimum flow rate within the range defined by T_{amb-cp-low-}down and T_{amb-cp-low-up} (when T_{amb-cp-low-down} <T_{amb-cp-low} < T_{amb-cp-low-up}). If the outside temperature T_{amb} is below T_{amb-limit2}, the system operates at the minimum flow rate. If it exceeds T_{amb-limit2}, the system runs at the maximum flow rate. These conditions were established based on tests that revealed the need to maintain a minimum flow rate at lower ambient temperatures (*e.g.*, <30°C) within the T_{amb-cp-low} range to prevent leaks. If so, at step **440,** the cooling water flow rate for cooling pad **150** is set to the minimum cooling water consumption level W_{cp-min} and then subprocess **420** proceeds to exit the subroutine. However, if not, subprocess **420** moves to step **442** where the the cooling water flow rate for cooling pad **150** is set to the maximum cooling water consumption level W_{cp-max} and then subprocess **420** proceeds to exit the subroutine in preparation for the subsequent subprocess **450.**

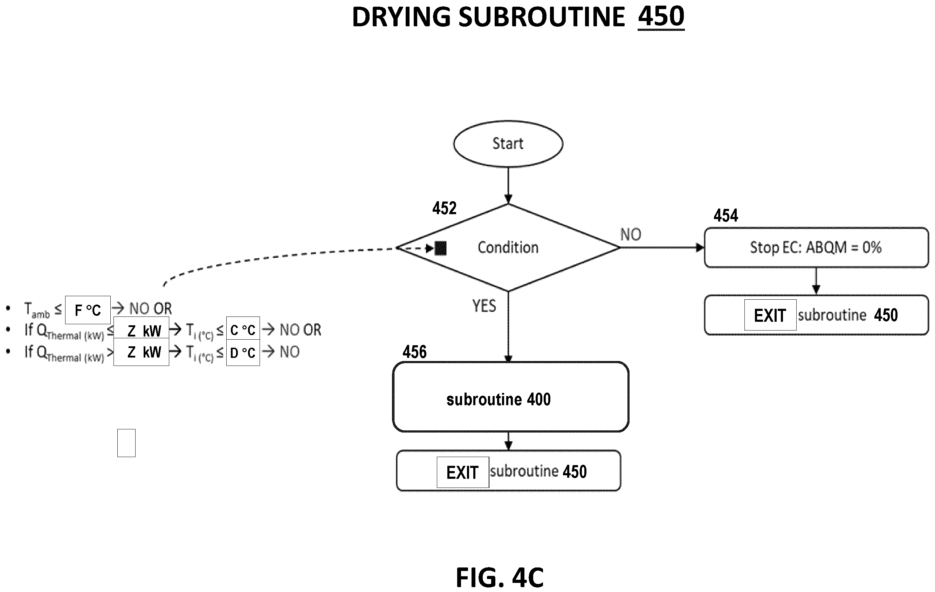

FIG. 4C illustrates a functional flow diagram depicting the processing steps of subprocess **450,** in accordance with non-limiting embodiments of the present technology. Subprocess **450** is directed to adjusting the drying levels of the evaporative cooling pads **150** to suitable levels.

Subprocess **450** commences at decision step **452** to determine whether the outside ambient air temperature T_{amb} is ≤ F °C and whether either the thermal load Q is ≤ Z kW and Tᵢ is ≤ C °C or the thermal load Q is > Z kW and Tᵢ is ≤ D °C. If any of these conditions are satisfied, at step **454,** subprocess **450** closes the smart flow control valve **208** to terminate the flow of evaporative cooling water W_{f} and subprocess **450** is exited If none of the conditions are met, at step **456** subprocess **450** returns to back to subprocess **400** and exits..

It will be appreciated that main process **300** and subprocesses **400, 420, 450** may be performed upon installation and may repeated continuously, at predetermined intervals, or upon detection of an anomaly.

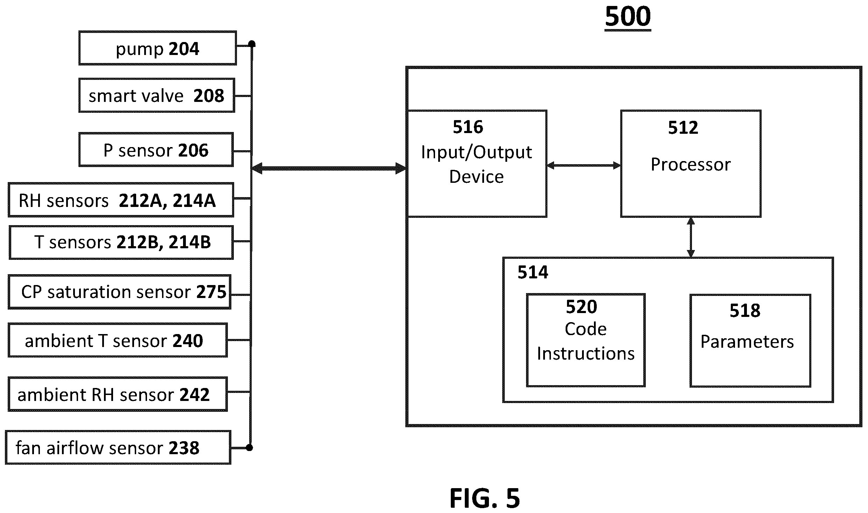

FIG. 5 illustrates a functional block diagram of monitoring controller **500** configured to execute the processing operations noted above, in accordance with an embodiment of the present technology.

As shown, the controller **500** comprises a processor or a plurality of cooperating processors (represented as a processor **512** for simplicity), a memory device or a plurality of memory devices (represented as a memory device **514** for simplicity), one or more input devices and one or more output devices, the input devices and the output devices being possibly combined in one or more input/output devices (represented as a single input/output device **516** for simplicity). The processor **512** is operatively connected to the memory device **514** and to the input/output device **516.** The memory device is configured to store a list **518** of relevant parameters. The memory device **514** may comprise a non-transitory computer-readable media for storing control logic instructions **520** that are executable by the processor **512** and, in particular, the executing process **300** for optimally controlling the application of cooling water to the evaporative cooling pad **150.**

The processor **512** is communicatively coupled, via the input/output interface **516,** to the smart control valve **208,** pump **204,** inlet evaporative cooling water temperature Tᵢ sensor **234,** ambient inlet relative humidity RHᵢ sensor **232,** outlet cooling water temperature Tₒ sensor **236,** pump pressure level sensor **206,** cooling water flow rate W_{f} sensor **210,** ambient mid-level cooling pad relative humidity RH_{amb-cp-mid} sensor **212A** and temperature T_{amb-cp-mid} sensors **212B,** ambient low-level cooling pad relative humidity RH_{amb-cp-low} sensor **214A** and temperature T_{amb-cp-low} sensor **214B,** fan airflow rate A_{f} sensor **238,** outside ambient air temperature T_{amb} sensor **240,** outside relative humidity RH_{amb} sensor **242,** and cooling pad saturation level sensor **275.**

With this architecture, monitoring controller **500** is able to receive data from the noted sensors in order to process the data, generate operational parameters/metrics, and execute the operations of main process **300** and incorporated subprocesses **400, 420, 450.**

In this manner, the disclosed non-limiting embodiments provide an evaporative cooling water arrangement for a datacenter dry cooler unit that is configured to achieve the optimal balance between the power level consumed by fan assembly for cooling purposes while minimizing the water used by the evaporative cooling water distribution unit in view of prevailing ambient weather conditions.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A datacenter dry cooling method (300, 400, 420, 450) for cooling a heat-generating electronic processing source, the datacenter associated with a dry cooler unit (10) that incorporates an air-to-water heat exchanger panel (20), an evaporative cooling pad (150), an evaporating cooling water distribution arrangement (200) for applying cooling water to the evaporative cooling pad (150), and a controller (500), the method comprising:
receiving, by the controller (500), temperature-, humidity-, and water flow-related data detected by respective sensors;
processing the received data to generate operational parameters that include:
a thermal load Q value based, in part, on an inlet cooling water temperature Tᵢ value and an outlet cooling water temperature Tₒ value,
a theoretical ambient cooling pad temperature T_{amb-cp-theo} value based, in part, on an outside ambient temperature T_{amb} value and an inlet relative humidity RHᵢ value,
a cooling water target flow rate W_{f-targ} based, in part, on the cooling water flow rate W_{f} applied to the cooling pad,
a cooling pad low-level temperature T_{amb-cp-low} value that ranges between an upper temperature limit T_{amb-cp-low-up} value and a lower temperature limit T_{amb-cp-low-down} value, and
a maximum cooling water consumption level W_{cp-max} value and a minimum cooling water consumption level W_{cp-min} value that are based, in part, on a theoretical cooling water consumption level W_{cp-theo};
determining a first condition comprising whether thermal load Q value is ≤ Z kW and Tᵢ is > C °C or whether the Q value is > Z kW and Tᵢ is > D °C, wherein in response to determining that the first condition is satisfied (*st.* 302):
determining a second condition comprising whether the outside ambient temperature T_{amb} value is ≥ B °C (*st.* 306), and
determining a third condition comprising whether the theoretical ambient temperature after the evaporative cooling pad T_{amb-cp-theo} value is ≤ A °C (*st.* 310);
wherein in response to determining that the second and third conditions are satisfied, an inlet cooling water temperature target T_{in-targ} value is set to A °C (*st.* 314).

2. The datacenter dry cooling method of claim 1, further comprising:
setting the target cooling water flow rate W_{f-targ} to the maximum cooling water consumption level W_{cp-max} (*st.* 402);
determining a fourth condition comprising whether the outside relative humidity RH_{amb} value is > 95% and the theoretical ambient temperature T_{amb-cp-theo} value ≤ A °C, wherein in response to determining that the fourth condition is satisfied, T_{mid-targ} is set to equal A°C (*st.* 404); and
determining a fifth condition comprising whether the outside relative humidity RH_{amb} value is > 95% and the theoretical ambient temperature T_{amb-cp-theo} value is > A °C, wherein in response to determining that the fifth condition is satisfied, T_{mid-targ} is set to equal T_{amb-cp-theo} (*st.* 404).

3. The datacenter dry cooling method of claims 1 or 2, wherein in response to determining that either the fourth or fifth conditions is satisfied (*st.* 422):
determining a sixth condition comprising whether the cooling pad low-level temperature T_{amb-cp-low} value is ≤ the upper temperature limit T_{amb-cp-low-up} value (*st*. 430); and
determining a seventh condition comprising whether the cooling pad low-level temperature T_{amb-cp-low} value is < the lower temperature limit T_{amb-cp-low-down} value (*st*. 434);
wherein, in response to determining that the sixth and seventh conditions are satisfied, setting the the target cooling water flow rate W_{f-targ} to the minimum cooling water consumption level W_{cp-min} (*st.* 436).

4. The datacenter dry cooling method of claim 3, wherein:
in response to determining that neither of the fourth or fifth conditions is satisfied (*st.* 422), setting the target cooling water flow rate W_{f-targ} to the maximum cooling water consumption level W_{cp-max} (*st.* 424);
in response to determining that the sixth condition is not satisfied (*st.* 430), setting the target cooling water flow rate W_{f-targ} to the maximum cooling water consumption level W_{cp-max} (*st.* 432);
in response to determining that the seventh condition is not satisfied (*st.* 434), determining whether the the outside ambient temperature T_{amb} value is ≤ temperature limit T_{amb}-ₗᵢₘᵢₜ₂ value E °C (*st.* 438) which determines whether the evaporative cooling system operates at maximum or minimum flow rate within the range defined by T_{amb-cp-low-}down and T_{amb-cp-low-up}, wherein if T_{amb} value is ≤ E °C, the target cooling water flow rate W_{f-targ} is set to W_{cp-min} (*st.* 440) and if T_{amb} value is > E °C, the target cooling water flow rate W_{f-targ} is set to W_{cp-max} (*st.* 442).

5. The datacenter dry cooling method of anyone of claims 1 to 4, further comprising:
determining an eighth condition comprising whether the outside ambient air temperature T_{amb} is ≤ F °C, whether the thermal load Q is ≤ Z kW and the water inlet temperature Tᵢ is ≤ C °C, or whether the thermal load Q is > Z kW and the water inlet temperature Tᵢ is not ≤ D °C; and
in response to determining that the eighth condition is satisfied, closing the smart flow control valve (208) to terminate the evaporative cooling water W_{f} flow to the cooling pad.

6. The datacenter dry cooling method of anyone of claims 1 to 5, further comprising:
receiving, by the controller (500), a cooling pad water saturation level sensor (275) disposed at different heights of the cooling pad to determine cooling pad water absorption levels at different cooling pad heights.

7. The datacenter dry cooling method of claim 6, wherein the cooling pad water saturation level sensor (275) comprises a cannula (275A) configured with an exposed opening to extract water samples and coupled to a capacitive, conductivity, or optical sensor.

8. The datacenter dry cooling method of claim 6, wherein the cooling pad water saturation level sensor (275) comprises a resistive probe (275B) configured to measure the resistance values indicative of saturation levels.

9. The datacenter dry cooling method of claim 6, wherein the cooling pad water saturation level sensor (275) comprises a high definition (HD) camera (275C) configured to observe the color of the cooling pad or flickering due to reflections caused by progressing water saturation levels.

10. The datacenter dry cooling method of claim 6, wherein the cooling pad water saturation level sensor (275) comprises a thermal camera configured to detect temperatures by capturing different levels of infrared light indicative of warm and cool areas of the cooling pad.

11. A datacenter dry cooling arrangement (200) for cooling a heat-generating electronic processing source, comprising:
an associated dry cooler unit (10) incorporating an air-to-water heat exchanger panel (20) with an evaporative cooling pad (150);
an evaporating cooling water distribution arrangement (220) configured to apply cooling water to the evaporative cooling pad (150);
an inlet evaporative cooling water temperature Tᵢ sensor (234) and outlet evaporative cooling water temperature detected by Tₒ sensor (236), evaporative cooling pad air outlet surface temperature sensors (212B, 214B), and outside ambient temperature sensor (240);
an inlet relative humidity RHᵢ sensor (232);
an output evaporative cooling water flow rate W_{f} sensor (210);
a cooling pad water saturation level sensor (275) disposed at different heights of the cooling pad to determine cooling pad water absorption levels at different cooling pad heights;
a controller (500) configured with executable instructions to operatively:
receive temperature-, water absorption-, and water flow-related data detected by respective sensors;
process the received data to generate operational parameters that include: a thermal load Q value based, in part, on an inlet cooling water temperature Tᵢ value and an outlet cooling water temperature Tₒ value, a theoretical ambient cooling pad temperature T_{amb-cp-theo} value based, in part, on an outside ambient temperature T_{amb} value and an inlet relative humidity RHᵢ value, a cooling water target flow rate W_{f-targ} based, in part, on the cooling water flow rate W_{f} applied to the cooling pad, a cooling pad low-level temperature T_{amb-cp-low} value ranging between an upper temperature limit T_{amb-cp-low-up} value and a lower temperature limit T_{amb-cp-low-down} value, and a maximum cooling water consumption level W_{cp-max} value and a minimum cooling water consumption level W_{cp-min} value that are based, in part, on a theoretical cooling water consumption level W_{cp-theo};
determine a first condition comprising whether thermal load Q value is ≤ Z kW and Tᵢ is > C °C or whether the Q value is > Z kW and Tᵢ is > D °C, wherein in response to determining that the first condition is satisfied (*st.* 302);
determine a second condition comprising whether the outside ambient temperature T_{amb} value is ≥ B °C (*st.* 306), and
determine a third condition comprising whether the theoretical ambient temperature after the evaporative cooling pad T_{amb-cp-theo} value is ≤ A °C (*st.* 310);
wherein in response to determining that the second and third conditions are satisfied, an inlet cooling water temperature target T_{in-targ} value is set to A °C (*st.* 314).

12. The datacenter dry cooling arrangement (200) of claim 11, wherein the controller (500) further operates to:
set the target cooling water flow rate W_{f-targ} to the maximum cooling water consumption level W_{cp-max};
determine a fourth condition comprising whether the outside relative humidity RH_{amb} value is > 95% and the theoretical ambient temperature T_{amb-cp-theo} value ≤ A °C, wherein in response to determining that the fourth condition is satisfied, T_{mid-targ} is set to equal A°C; and
determining a fifth condition comprising whether the outside relative humidity RH_{amb} value is > 95% and the theoretical ambient temperature T_{amb-cp-theo} value is > A °C, wherein in response to determining that the fifth condition is satisfied, T_{mid-targ} is set to equal T_{amb-cp-theo}.

13. The datacenter dry cooling arrangement (200) of claims 11 or 12, wherein the controller (500) further operates to:
determine a sixth condition comprising whether the cooling pad low-level temperature T_{amb-cp-low} value is ≤ the upper temperature limit T_{amb-cp-low-up} value; and
determine a seventh condition comprising whether the cooling pad low-level temperature T_{amb-cp-low} value is < the lower temperature limit T_{amb-cp-low-down} value;
wherein, in response to determining that the sixth and seventh conditions are satisfied, set the the target cooling water flow rate W_{f-targ} to the minimum cooling water consumption level W_{cp-min}.

14. The datacenter dry cooling arrangement (200) of anyone of claims 11 to 13, wherein the controller (500) further operates to:
in response to determining that neither of the fourth or fifth conditions is satisfied, set the target cooling water flow rate W_{f-targ} to the maximum cooling water consumption level W_{cp-max};
in response to determining that the sixth condition is not satisfied, set the target cooling water flow rate W_{f-targ} to the maximum cooling water consumption level W_{cp-max};
in response to determining that the seventh condition is not satisfied, determining whether the the outside ambient temperature T_{amb} value is ≤ temperature limit T_{amb-limit2} value E °C which determines whether the evaporative cooling system operates at maximum or minimum flow rate within the range defined by T_{amb-cp-low-}down and T_{amb-cp-low-up}, wherein if T_{amb} value is ≤ E °C, the target cooling water flow rate W_{f-targ} is set to W_{cp-min} and if T_{amb} value is > E °C, the target cooling water flow rate W_{f-targ} is set to W_{cp-max}.

15. The datacenter dry cooling arrangement (200) of anyone of claims 11 to 14, wherein the controller (500) further operates to:
determine an eighth condition comprising whether the outside ambient air temperature T_{amb} is ≤ F °C, whether the thermal load Q is ≤ Z kW and the water inlet temperature Tᵢ is ≤ C °C, or whether the thermal load Q is > Z kW and the water inlet temperature Tᵢ is not ≤ D °C; and
in response to determining that the eighth condition is satisfied, close the smart flow control valve (208) to terminate the evaporative cooling water W_{f} flow to the cooling pad.

## Amended claims

### Amended claims in accordance with Rule 137(2) EPC.

1. A datacenter dry cooling method (300, 400, 420, 450) for cooling a heat-generating electronic processing source, the datacenter associated with a dry cooler unit (10) that incorporates an air-to-water heat exchanger panel (20), an evaporative cooling pad (150), an evaporating cooling water distribution arrangement (200) incorporating a pump unit (204) and a volume control valve (208) for controlling and applying a flow rate of cooling water to the evaporative cooling pad (150), and a controller (500), the method comprising:
receiving, by the controller (500), temperature-, humidity-, and water flow-related data detected by respective sensors;
processing the received data to determine operational parameters that include:
a thermal load Q value based, in part, on an inlet cooling water temperature Tᵢ value and an outlet cooling water temperature Tₒ value,
a theoretical ambient cooling pad temperature T_{amb-cp-theo} value based, in part, on an outside ambient temperature T_{amb} value and an inlet relative humidity RHᵢ value,
a cooling water target flow rate W_{f-targ} based, in part, on the cooling water flow rate W_{f} applied to the cooling pad,
a cooling pad low-level temperature T_{amb-cp-low} value that ranges between an upper temperature limit T_{amb-cp-low-up} value and a lower temperature **limit** T_{amb-cp-low-down} value, and
a maximum cooling water consumption **level** W_{cp-max} value and a minimum cooling water consumption level W_{cp-min} value that are based, in part, on a theoretical cooling water consumption level W_{cp-theo};
determining a first condition comprising whether thermal load Q value is ≤ Z kW and Tᵢ is > C °C or whether the Q value is > Z kW and Tᵢ is > D °C, wherein in response to determining that the first condition is not satisfied, wait X seconds and redetermine the operational parameters (st. 304) and, in response to determining that the first condition is, satisfied (st. 302):
determining a second condition comprising whether the outside ambient temperature T_{amb} value is ≥ B °C *(st.* 306), and
determining a third condition comprising whether the theoretical ambient temperature after the evaporative cooling pad T_{amb-cp-theo} value is ≤ A °C *(st.* 310);
wherein in response to determining that the second or third conditions are not satisfied *(st.* 308), wait X seconds and redetermine the operational parameters and, in response to determining that the second and third conditions are satisfied, setting an inlet cooling water temperature target T_{in-targ} value to A °C *(st.* 314).

2. The datacenter dry cooling method of claim 1, further comprising:
setting the target cooling water flow rate W_{f-targ} to the maximum cooling water consumption level W_{cp-max} (*st.* 402);
determining a fourth condition comprising whether the outside relative humidity RH_{amb} value is > 95% and the theoretical ambient temperature T_{amb-cp-theo} value ≤ A °C, wherein in response to determining that the fourth condition is satisfied, T_{mid-targ} is set to equal A°C *(st.* 404);
determining a fifth condition comprising whether the outside relative humidity RH_{amb} value is > 95% and the theoretical ambient temperature T_{amb-cp-theo} value is > A °C, wherein in response to determining that the fifth condition is satisfied, T_{mid-targ} **is set to equal** T_{amb-cp-theo} (st. 404); and
wherein, in response to determining that the fourth or fifth condition are not satisfied, reset the target cooling water flow rate W_{f-targ}.

3. The datacenter dry cooling method of claims 1 or 2, wherein in response to determining that either the fourth or fifth conditions is satisfied (st. 422):
determining a sixth condition comprising whether the cooling pad low-level temperature T_{amb-cp-low} value is ≤ the upper temperature **limit** T_{amb-cp-low-up} **value** *(st.* 430); and
determining a seventh condition comprising whether the cooling pad low-level temperature T_{amb-cp-low} value is < the lower temperature **limit** T_{amb-cp-low-down} value *(st.* 434);
wherein, in response to determining that the sixth and seventh conditions are satisfied, setting the the target cooling water flow rate W_{f-targ} to the minimum cooling water consumption level W_{cp-min} (*st*. 436).

4. The datacenter dry cooling method of claim 3, wherein:
in response to determining that neither of the fourth or fifth conditions is satisfied (st. 422), setting the target cooling water flow rate W_{f-targ} to the maximum cooling water consumption level W_{cp-max} (st. 424);
in response to determining that the sixth condition is not satisfied (st. 430), setting the target cooling water flow rate W_{f-targ} to the maximum cooling water consumption **level** W_{cp-max} (st. 432);
in response to determining that the seventh condition is not satisfied (st. 434), determining whether the the outside ambient temperature T_{amb} value is ≤ temperature limit T_{amb-limit2} value E °C *(st.* 438) which determines whether the evaporative cooling system operates at maximum or minimum flow rate within the range defined by *T_{amb-cp-low}-down* and *T_{amb-cp-low-up}, wherein if* T_{amb} value is ≤ E °C, the target cooling water flow rate W_{f-targ} is set to W_{cp-min} *(st.* 440) and if T_{amb} value is > E °C, the target cooling water flow rate W_{f-targ} **is set** to W_{cp-max} (st. 442).

5. The datacenter dry cooling method of anyone of claims 1 to 4, further comprising:
determining an eighth condition comprising whether the outside ambient air temperature T_{amb} is ≤ F °C, whether the thermal load Q is ≤ Z kW and the water inlet temperature Tᵢ is ≤ C °C, or whether the thermal load Q is > Z kW and the water inlet temperature Tᵢ is not ≤ D °C; and
in response to determining that the eighth condition is satisfied, closing the smart flow control valve (208) to terminate the evaporative cooling water W_{f} flow to the cooling pad.

6. The datacenter dry cooling method of anyone of claims 1 to 5, further comprising:
receiving, by the controller (500), a cooling pad water saturation level sensor (275) disposed at different heights of the cooling pad to determine cooling pad water absorption levels at different cooling pad heights.

7. The datacenter dry cooling method of claim 6, wherein the cooling pad water saturation level sensor (275) comprises a cannula (275A) configured with an exposed opening to extract water samples and coupled to a capacitive, conductivity, or optical sensor.

8. The datacenter dry cooling method of claim 6, wherein the cooling pad water saturation level sensor (275) comprises a resistive probe (275B) configured to measure the resistance values indicative of saturation levels.

9. The datacenter dry cooling method of claim 6, wherein the cooling pad water saturation level sensor (275) comprises a high definition (HD) camera (275C) configured to observe the color of the cooling pad or flickering due to reflections caused by progressing water saturation levels.

10. The datacenter dry cooling method of claim 6, wherein the cooling pad water saturation level sensor (275) comprises a thermal camera configured to detect temperatures by capturing different levels of infrared light indicative of warm and cool areas of the cooling pad.

11. A datacenter dry cooling arrangement (200) for cooling a heat-generating electronic processing source, comprising:
an associated dry cooler unit (10) incorporating an air-to-water heat exchanger panel (20) with an evaporative cooling pad (150);
an evaporating cooling water distribution arrangement (220) configured to apply cooling water to the evaporative cooling pad (150), the distribution arrangement (220) incorporating a pump unit (204) and a volume control valve (208) for controlling and applying a flow rate of cooling water to the evaporative cooling pad (150);
an inlet evaporative cooling water temperature Tᵢ sensor (234) and outlet evaporative cooling water temperature detected by Tₒ sensor (236), evaporative cooling pad air outlet surface temperature sensors (212B, 214B), and outside ambient temperature sensor (240);
an inlet relative humidity RHᵢ sensor (232);
an output evaporative cooling water flow rate W_{f} sensor (210);
a controller (500) configured with executable instructions to operatively:
receive temperature and water flow-related data detected by respective sensors;
process the received data to generate operational parameters that include: a thermal load Q value based, in part, on an inlet cooling water temperature Tᵢ value and an outlet cooling water temperature Tₒ value, a theoretical ambient cooling pad temperature T_{amb-cp-theo} value based, in part, on an outside ambient temperature T_{amb} value and an inlet relative humidity RHᵢ value, a cooling water target flow rate W_{f-targ} based, in part, on the cooling water flow rate W_{f} applied to the cooling pad, a cooling pad low-level temperature T_{amb-cp-low} value ranging between an upper temperature limit T_{amb-cp-low-up} value and a lower temperature **limit** T_{amb-cp-low-down} value, and a maximum cooling water consumption level W_{cp-max} value and a minimum cooling water consumption level W_{cp-min} value that are based, in part, on a theoretical cooling water consumption level W_{cp-theo};
determine a first condition comprising whether thermal load Q value is ≤ Z kW and Tᵢ is > C °C or whether the Q value is > Z kW and Tᵢ is > D °C, wherein in response to determining that the first condition is not satisfied, wait X seconds and redetermine the operational parameters (st. 304) and, in response to determining that the first condition is, satisfied (st. 302);
determine a second condition comprising whether the outside ambient temperature T_{amb} value is ≥ B °C *(st.* 306), and
determine a third condition comprising whether the theoretical ambient temperature after the evaporative cooling pad T_{amb-cp-theo} value is ≤ A °C *(st.* 310);
wherein in response to determining that the second or third conditions are not satisfied *(st.* 308), wait X seconds and redetermine the operational parameters and, in response to determining that the second and third conditions are satisfied, setting an inlet cooling water temperature target T_{in-targ} value to A °C *(st.* 314).

12. The datacenter dry cooling arrangement (200) of claim 11, wherein the controller (500) further operates to:
set the target cooling water flow rate W_{f-targ} to the maximum cooling water consumption level W_{cp-max};
determine a fourth condition comprising whether the outside relative humidity RH_{amb} value is > 95% and the theoretical ambient temperature T_{amb-cp-theo} value ≤ A °C, wherein in response to determining that the fourth condition is satisfied, T_{mid-targ} is set to equal A°C;
determining a fifth condition comprising whether the outside relative humidity RH_{amb} value is > 95% and the theoretical ambient temperature T_{amb-cp-theo} value is > A °C, wherein in response to determining that the fifth condition is satisfied, T_{mid-targ} **is set to equal** T_{amb-cp-theo}; and
wherein, in response to determining that the fourth or fifth condition are not satisfied, reset the target cooling water flow rate W_{f-targ}.

13. The datacenter dry cooling arrangement (200) of claim 11 or 12, wherein the controller (500) further operates to:
determine a sixth condition comprising whether the cooling pad low-level temperature T_{amb-cp-low} value is ≤ the upper temperature limit T_{amb-cp-low-up} value; and
determine a seventh condition comprising whether the cooling pad low-level temperature T_{amb-cp-low} value is < the lower temperature **limit** T_{amb-cp-low-down} value;
wherein, in response to determining that the sixth and seventh conditions are satisfied, set the the target cooling water flow rate W_{f-targ} to the minimum cooling water consumption level W_{cp-min}.

14. The datacenter dry cooling arrangement (200) of anyone of claims 11 to 13, wherein the controller (500) further operates to:
in response to determining that neither of the fourth or fifth conditions is satisfied, set the target cooling water flow rate W_{f-targ} to the maximum cooling water consumption **level** W_{cp-max};
in response to determining that the sixth condition is not satisfied, set the target cooling water flow rate W_{f-targ} to the maximum cooling water consumption level W_{cp-max};
in response to determining that the seventh condition is not satisfied, determining whether the the outside ambient temperature T_{amb} value is ≤ temperature limit T_{amb-limit2} value E °C which determines whether the evaporative cooling system operates at maximum or minimum flow rate within the range defined by *T_{amb-cp-low-down}* and *T_{amb-cp-low-up}, wherein if* T_{amb} value is ≤ E °C, the target cooling water flow rate W_{f-targ} is set to W_{cp-min} and if T_{amb} value is > E °C, the target cooling water flow rate W_{f-targ} is set to W_{cp-max}.

15. The datacenter dry cooling arrangement (200) of anyone of claims 11 to 14, wherein the controller (500) further operates to:
determine an eighth condition comprising whether the outside ambient air temperature T_{amb} is ≤ F °C, whether the thermal load Q is ≤ Z kW and the water inlet temperature Tᵢ is ≤ C °C, or whether the thermal load Q is > Z kW and the water inlet temperature Tᵢ is not ≤ D °C; and
in response to determining that the eighth condition is satisfied, close the smart flow control valve (208) to terminate the evaporative cooling water W_{f} flow to the cooling pad.
